Europäisches Patentamt

European Patent Office

Office européen des brevets

(19)

(11) **EP 0 560 350 B1**

(12) **EUROPEAN PATENT SPECIFICATION**

(45) Date of publication and mention
of the grant of the patent:
**19.06.2002   Bulletin 2002/25**

(51) Int Cl.[7]: **G01R 33/06**

(21) Application number: **93103919.2**

(22) Date of filing: **11.03.1993**

(54) **Magneto-resistance effect element**

Magnetowiderstandeffekt-Element

Elément à effet magnéto-résistive

(84) Designated Contracting States:
**DE FR NL**

(30) Priority: **13.03.1992   JP 5493492**

(43) Date of publication of application:
**15.09.1993   Bulletin 1993/37**

(73) Proprietor:**MATSUSHITA ELECTRIC INDUSTRIAL CO., LTD.**
**Kadoma-shi, Osaka 571-8501 (JP)**

(72) Inventors:
 • **Sakakima, Hiroshi**
  **Tsuzuki-gun, Kyoto-fu (JP)**
 • **Satomi, Mitsuo**
  **Katano-shi, Osaka-fu (JP)**

 • **Takeuchi, Hiroshi**
  **Matsubara-shi, Osaka-fu (JP)**

(74) Representative: **Eisenführ, Speiser & Partner**
  **Martinistrasse 24**
  **28195 Bremen (DE)**

(56) References cited:
  **EP-A- 0 406 060**        **EP-A- 0 498 344**
  **DE-A- 3 609 006**        **DE-C- 3 820 475**
  **US-A- 4 296 377**

 • **T. SHINJO ET AL: "Large magnetoresistance of Field-Induced Giant Ferrimagnetic Multilayers", JOURNAL OT THE PHYSICAL SOCIETY OF JAPAN, TOKYO, 1990, vol. 59, no. 9, pages 3061 to 3064**

**Description**

BACKGROUND OF THE INVENTION

1. Field of the invention

The present invention relates to a magneto-resistance sensor.

2. Prior art

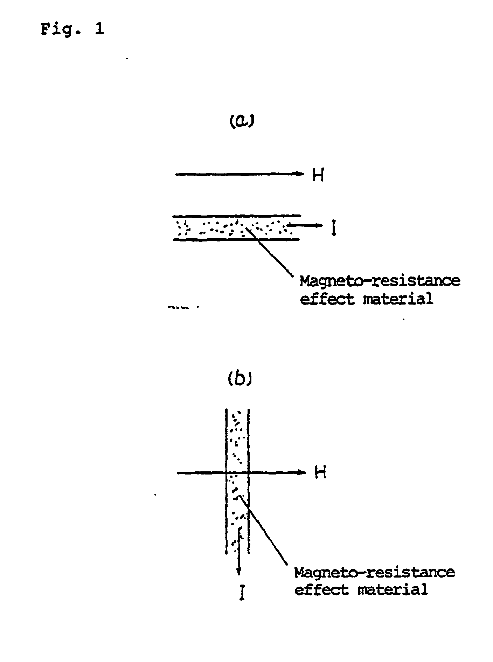

Development of magneto-resistance sensors (hereinafter called MR sensor) and magneto-resistance heads (hereinafter called MR head) utilizing magneto-resistance elements in which mainly $Ni_{0.8}Fe_{0.2}$ permalloy or $Ni_{0.8}Co_{0.2}$ alloy film is used as magnetic material has been promoted. In the case of these magneto-resistance effect materials, the magneto-resistance variation rate (hereinafter called $\Delta R/R$) is about 2.5% and when it is actually used as the sensor or head, the magneto-resistance effect material is usually patterned as shown in Fig. 1 (b) and the element is so designed that the direction of electric current to run through the magneto-resistance effect material and the direction of magnetic field to be sensed roughly form a right angle. The reason for it is that when the direction of electric current and the direction of magnetic field are in parallel, the magneto-resistance effect material practically generates no magneto-resistance variation rate ($\Delta R/R$). In order to make the magneto-resistance element more sensitive, it is desired that the magneto-resistance material has a larger magneto-resistance variation rate ($\Delta R/R$).

In recent years it has been discovered that a large magneto-resistance effect is obtained with an [Fe/Cr], [Co/Ru] artificial lattice membrane which formes anti-ferrogmagnetic bonding via a metallic non-magnetic thin film made of Cr, Ru, etc. (Physical Review Letter Vol. 61, P2472, 1988; ditto Vol. 64, P2304, 1990). A large magneto-resistance effect was also found with an [Ni-Fe/Cu/Co] artificial lattice membrane using a magnetic thin film Ni-Fe and Co separated by a metallic non-magnetic thin Cu film which is not making magnetic bonding and they obtained a film with $\Delta R/R$ of about 10% at room temperature and with impression of a magnetic field of 3K Oe (Journal of Physical Society of Japan Vol. 59, P3061, 1990). A large magneto-resistance effect was further discovered with [Ni-Fe-Co/Cu/Co], [Ni-Fe-Co/Cu] artificial lattice films using Ni-Fe-Cu/Co magnetic thin film which makes an anti-ferromagnetic bonding via Cu and they obtained a film with $\Delta R/R$ of about 15% at room temperature and impression magnetic field of 0.5 KOe (Technical Research Report MR91-9 of the Society of Electronic Data Communication). However, when such artificial metallic lattice film is patterned and the element is so constructed that the direction of the electric current to run through the magneto-resistance effect material and the direction of the magnetic field to be sensed make roughly a right angle as in the case of conventional magneto-resistance materials, no magnetic sensor or magnetic head with preferred characteristics is obtained.

T. Shinio and H. Yamamoto (Journal of the Physical Society of Japan, 59 (1990) 3061 - 3064 disclose the preparation of multilayers consisting of two magnetic components with different anisotropies by successively depositing Co, Cu, $Ni_{80}Fe_{20}$ and Cu layers. By applying a moderate field, the two magnetizations are oriented antiparallel with each other, and then the electric resistance significantly increases due to spin-dependent electron scattering. It is reported by the authors that a magnetoresistance change of 9,9 % at 300 K was observed in [Co(30Å)/Cu(50Å)/NiFe (30Å)/Cu(50Å)] x 15. It is further reported that almost the same results were obtained even when the magnetic field direction was parallel to the current direction. The dependence of the resistance on the direction of magnetization (i. e., MR effect in the classic definition) is reported to be very small.

It is the object of the present invention to provide a magneto-resistive sensor exhibiting an improved MR ratio.

This object is attained by the magneto-resistive sensor according to claim 1. Preferred embodiments of this magneto-resistive sensor are defined in the subclaims.

SUMMARY OF THE INVENTION

The present invention provides a high sensitive magneto-resistance sensor which exploits the characteristics of the metallic artificial lattice film by using an artificial metallic lattice membrane and a novel construction which is different from the conventional film made of the magneto-resistance effect material.

The magneto-resistance sensor of the present invention is constructed as shown in Fig. 1 (a). The direction of the most part of the electric current running through the patterned magneto-resistance effect material should is roughly in parallel with the direction of the aforesaid external magnetic field. The magneto-resistance effect material comprises an artificial metallic lattice membrane composed of a magnetic thin film layer and a metallic non-magnetic thin film layer, as defined in claim 1.

It is preferred that the artificial lattice membrane is made of a magnetic thin film layer [1] and of a metallic non-magnetic thin film layer [2] which are alternatingly laminated wherein the magnetic thin film layer [1] is made of

$$(Ni_xCo_{1-x})_x\ Fe_{1-x'} \tag{1}$$

wherein x and x' are respectively, by atomic composition ratio,

$$0.6 \leq x \leq 1.0,\ 0.7 \leq x' \leq 1.0 \tag{2}$$

and the metallic non-magnetic thin film layer [2] is made of anyone of Cu, Ag, Au, Pt or Ru, preferably Cu.

According to another preferred embodiment, a magnetic thin film layer [3] and a non-magnetic metallic thin film layer [2] are alternatingly laminated wherein the magnetic thin film layer [3] is made of

$$(Co_yNi_{1-y})_zFe_{1-z} \tag{3}$$

wherein Y and Z are respectively, by the atomic composition ratio,

$$0.4 \leq y \leq 1.0,\ 0.8 \leq z \leq 1.0 \tag{4}$$

and the non-magnetic metallic thin film layer [2] is made of anyone of Cu, Ag, Au, Pt or Ru, preferably Cu.

Furthermore, the lattice membrane may have such construction that the magnetic thin film layer [1] and the magnetic thin film layer [3] are interchangeably laminated and a non-magnetic metallic thin film layer [2] is interposed between said laminated magnetic thin film layers. Here, the magnetic thin film layer [1] is made of a soft magnetic material with small magnetostricture and small coercive force and the magnetic thin film layer [3] is made of the magnetic material with small magnetostricture but different from magnetic thin film layer [1], the formulae (2) and (4) being within the composition range required to satisfy said conditions. The magnetic thin film layer [1] may also be made of a system other than such 3-element system as above; it may be a 2-element magnetic thin film layer made of Ni-Fe or Ni-Co etc. which indicates soft magnetism and has a relatively large $\Delta R/R$.

When the non-magnetic metallic thin film layer [2] is thin enough, the film layers may be magnetically bonded via the non-magnetic metallic thin film layer [2] and when such magnetic bonding is the so-called RKKY-type bonding, the bonding of the magnetic thin film layers becomes anti-ferromagnetic bonding if the thickness of the non-magnetic metallic thin film layer should be thin enough [2] i.e. around 0.9 nm (9 Å) or 2 nm (20 Å) as defined in claim 1 and as indicated in the Examples given below), thus producing a large magneto-resistance effect. When they are bonded anti-ferromagnetically, the spin scattering of the conductive electrons becomes large and a large magneto-resistance ($\Delta R/R$) is obtained. When the magneto-resistance element as shown in Fig. 1 (a) is manufactured by patterning the artificial metallic lattice membrane composed of such a magnetic thin film layer and non-magnetic metallic layer, a magneto-resistance effect element of preferred characteristics is obtained if it is composed in such way that the majority of the current running through the magneto-resistance effect material has a direction roughly parallel to the direction of said external magnetic field.

## BRIEF DESCRIPTION OF THE DRAWING

Fig. 1 (a) indicates an example of the construction of the present invention wherein the direction of the magnetic field H and the direction of current I are in parallel while Fig. 1 (b) indicates an example of the conventional construction where the direction of the magnetic field H and the direction of current I are in right angle.

Fig. 2 indicates an example of the manufactured magneto-resistance element of the present invention.

## DESCRIPTION OF PREFERRED EMBODIMENT

Ni-rich Ni-Co-Fe alloy given in formula (1) shows small magnetostricture and soft magnetism when its composition satisfied formula (2). Typical examples of it are $Ni_{0.8}\ Co_{0.1}Fe_{0.1}$, $Ni_{0.8}Fe_{0.2}$, $Ni_{0.8}Co_{0.2}$ etc. If necessary, Nb, Mo, Cr, W, Ru etc. may be added to the composition given in formula (1) to improve soft magnetism or to improve the abrasion resistance and corrosion resistance. Co-rich Co-Ni-Fe alloys which satisfy formula (3) show relatively small magneto stricture and semi-rigid magnetic characteristics when they satisfy formula (4). A typical example is $Co_{0.9}Fe_{0.1}$, etc. In the case of such an magnetic thin film layer, when its thickness is less than 0.5 nm (5 Å), it causes such problems as decrease of magnetization at room temperature due to the decrease of Curie temperature though it varies depending on the composition. In the practical use, besides the magneto-resistance element being used with a total film thickness of several hundred angstrom, it is necessary to make the thickness of each magnetic film layer less than 10 nm (100 Å) preferably less than 5 nm (50 Å), in order to profitably utilize the lamination effect as in the case of the present invention. Therefore the thickness of these magnetic thin film layers is 0.5 to 5 nm (5-50 Å).

The magnetic thin film layer [1] is required to be a film with low magnetostricture having excellent soft magnetic characteristics. This is because in the practical use it is required to function in a weak magnetic field and when it is used for MR head etc., a large magnetostricture causes large noise. An example of the film which satisfies such conditions is the Ni-rich Ni-Fe-Co type film as indicated by the aforesaid formulae (1) and (2). The magnetic thin film layer [3] is also preferred to have small magnetostricture due to the same reasons as above; a magneto-resistance element with $\Delta R/R$ larger than those of the elements composed of only magnetic thin film layer [1] and non-magnetic metallic thin film layer [2] may be obtained when Co-rich Co-Ni-Fe film indicated by the aforesaid formula (3) and formula (4) which is different from the magnetic thin film layer [1] is used in combination with the aforesaid magnetic thin film layer [1]. The magneto-resistance effect element composed of only the magnetic thin film layer [3] and non-magnetic metallic thin film layer [2] is also effective when the magnetic field to be sensed is large and a large $\Delta R/R$ is required.

The magnetic thin film layer to be interposed between the magnetic thin film layers [1] (or [1] and [3]) is required to indicate a low reactivity at its interface to the magnetic thin film layer [1] (or [1] and [3]) which has the composition defined by the above formulae (1)-(4), and it is also required to be non-magnetic. Therefore Cu, Ag, Au, Pt, Ru etc. are suitable and the most preferred film is the one made of Cu. When the thickness of non-magnetic metallic layer [2] is more than 5 nm (50 Å), the magnetic bond between magnetic thin film layer [1] (or [1] and [3]) which are bonded via the non-magnetic metallic thin film layer [2] weakens severely, whereas when there exists no non-magnetic metallic thin film layer [2] or when its thickness is less than 0.5 nm (5 Å), the magnetic thin film layers [1] (or [1] and [3]) mutually make ferromagnetic bonding and the state as shown in Fig. 1 (a) can not be realized and no large magneto-resistance effect is obtained. Therefore, the thickness of the non-magnetic metallic thin film layer [2] is 0.5 to 5 nm (5-50 Å). To obtain a particularly large $\Delta R/R$, the thickness of the non-magnetic metallic thin film layer [2] is made about 0.9 nm (9 Å) i.e., 0.6 to 1.2 nm (6-12 Å) or about 2 nm (20 Å) i.e., 1.7 to 2.3 nm (17-23 Å) as indicated in the Examples and as defined in claim 1. When soft magnetic characteristics and a large $\Delta R/R$ is required, it is desirable to use the magnetic thin film layer [1] and to make the thickness of the non-magnetic metallic thin film layer [2] to be 0.6 to 1.2 nm (6-12 Å).

Hereinafter is described the effect of the present invention in reference to the concrete Examples.

Example 1

A magneto-resistance element with the following composition was formed on a glass substrate using a multifactor sputtering element, wherein N was the number of repetitions and was varied so that the total film thickness became 200 nm (2000 Å)

A:[Ni-Co-Fe(20)/Cu(20)/Co(20)/Cu(20)]$^N$

(The figures inside the parenthesis represent the thickness in Å, 20 Å = 2 nm.)

For the target, $Ni_{0.8}Co_{0.1}Fe_{0.1}$ (for magnetic layer [1]), $Co_{0.9}Fe_{0.1}$ (magnetic layer [3]) and Cu (non-magnetic metallic layer [2]) with diameter of 80 mm were used and the film thickness was controlled by the shutter.

In the same way, using $Ni_{0.8}Co_{0.05}Fe_{0.15}$ (magnetic layer [1]), $Ni_{0.8}Co_{0.2}$ (magnetic layer [3]) and Cu (non-magnetic metallic layer [2]) with diameter of 80 mm for the target,

B: (Ni-Co-Fe(30)/Cu(9)]$^{N1}$
C: [Ni-Co(40)/Cu(9)]$^{N2}$

were prepared, wherein N1 and N2 are the repetition frequencies which were varied so that the total thickness became about 200 nm (2,000 Å).

(The figures in the parenthesis represent the thickness in Å, see above.)

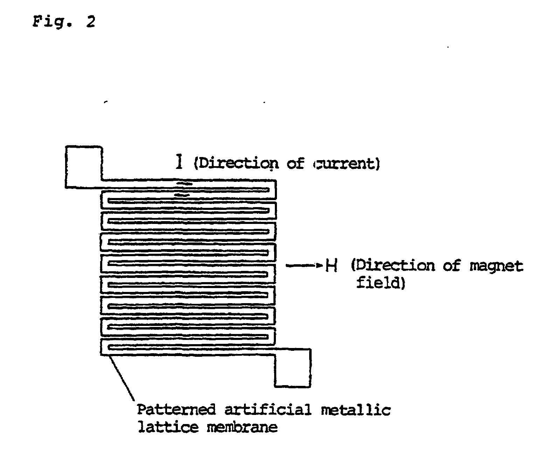

It was patterned into the shape as shown in Fig. 2 and the magneto-resistance element wherein the direction of the magnetic field to be sensed and the direction of current of the aforesaid artificial metallic lattice magneto-resistance film become mutually parallel. For comparison, a magneto-resistance element where the direction of the magnetic field to be sensed and the direction of current of the said artificial metallic lattice magneto-resistance film are in right angle was also manufactured. At the same time, magneto-resistance elements where the direction of the magnetic field to be sensed and the direction of the current of most of the Ni-Fe film are in parallel and those where it is in right angle were manufactured with conventional Ni-Fe films and their characteristics were compared. MR characteristics ($\Delta R/R$) of thus obtained magneto-resistance elements were measured at room temperature at maximum impression magnetic field of 500 0e. The obtained values (%) are shown in Table 1.

Table 1

| Magneto-resistance effect membrane | Direction of magnetic field and electric current | ΔR/R (%) |
|---|---|---|
| A | Parallel | 15 |
| | Right angle | 2 |
| | 30 ° | 10 |
| | 45° | 5 |
| B | Parallel | 20 |
| | Right angle | 1 |
| C | Parallel | 18 |
| | Right angle | 1 |
| Ni-Fe | Parallel | 0 |
| | Right angle | 2 |

As indicated in Table 1, the magneto-resistance effect element of novel construction where the artificial metallic lattice film of the present invention is used as the magneto-resistance effect film and where the direction of the current and that of the magnetic field are not in parallel as in the case of the conventional element indicates a large MR characteristic which has been impossible with the magneto-resistance effect element using the conventional Ni-Fe film. When the dependency of MR characteristics on the direction of magnetic field is investigated, it was found that MR characteristics are improved as the angle made by the direction of the impressed magnetic field and the direction of current of magneto-resistance effect element of the present invention becomes smaller (in other words closer to parallel) and in order that the characteristics of the material of the present invention is superior to that of the conventional material such as Ni-Co, it is necessary that the angle is less than 45°, preferably less than 30°.

As stated above, the present invention enables to obtain the magneto-resistance element which indicates a large magneto-resistance effect at room temperature and under low impression magnetic field, through employment of such composition as effectively utilizes the characteristics of the artificial, metallic lattice membrane and therefore the material of the present invention is suitable for application to the high sensitivity MR sensor, etc.

**Claims**

1.  A magneto-resistive sensor wherein,
    an electric current flows through a magneto-resistive material to measure the strength of an external magnetic field via the resistance change of said magneto-resistive material caused by said magnetic field,
    the demagnetizing factor of said magneto-resistive material in the direction of the current flow is smaller than that in the other directions,
    the direction of said external magnetic field is substantially parallel to the direction of the current flow, and
    said magneto-resistive material is composed of an artificial metallic lattice membrane comprising a structure wherein a magnetic thin film layer and a non-magnetic metallic thin film layer are alternatingly laminated,
    **characterized in that**
    said magnetic thin film layer has a thickness of 0.5 to 5 nm (5 to 50 Å) and said non-magnetic metallic thin film layer has a thickness of 0.6 to 1.2 nm (6 to 12 Å) or 1.7 to 2.3 nm (17 to 23 Å).

2.  The sensor according to claim 1 wherein said magnetic thin film layer is made of $(Ni_xCo_{1-x})_{x'} Fe_{1-x'}$ in which x is 0,6 to 1,0 and x' is 0,7 to 1,0.

3.  The effect sensor according to claim 1 wherein said magnetic thin film layer is made of $(Co_yNi_{1-y})_zFe_{1-z}$ in which y is 0,4 to 1,0 and z is 0,8 to 1,0.

4.  The sensor according to claim 1 wherein said magneto-resistance effect material comprises first and second magnetic thin layers and a non-magnetic thin film layer sandwiched therebetween, the first magnetic thin layer is made of $(Ni_xCo_{1-x})_{x'}Fe_{1-x'}$ and the second magnetic thin layer is made of $(Co_yNi_{1-y})_zFe_{1-z}$ in which x is 0,6 to 1,0, x' is 0,7 to 1,0, y is 0,4-1,0 and z is 0,8 to 1,0.

5.  The sensor according to anyone of the preceding claims wherein the part wherein the angle made by the direction of the external magnetic field and the direction of electric current running though the magneto-resistance effect material is less than 45° occupies more than 50 %.

6. The sensor according to anyone of the preceding claims wherein the non-magnetic metallic thin film layer is formed from Cu, Ag, Au, Pt or Ru.


**Patentansprüche**

1. Magnetowiderstandssensor, bei dem

durch ein Magnetowiderstandsmaterial ein elektrischer Strom fließt, um die Stärke eines äußeren magnetischen Feldes über die von dem magnetischen Feld verursachte Widerstandsänderung des Magnetowiderstandsmaterials zu messen,

der Entmagnetisierungsfaktor des Magnetowiderstandsmaterials in Richtung des Stromflusses kleiner ist als in den anderen Richtungen, die Richtung des äußeren magnetischen Feldes im Wesentlichen parallel zur Richtung des Stromflusses ist und

das Magnetowiderstandsmaterial aufgebaut ist aus einer künstlichen Gittermembran aus Metall, die eine Struktur aufweist, bei der eine magnetische Dünnschicht und eine nichtmagnetische Dünnschicht aus Metall alternierend aufeinanderlaminiert sind,

**dadurch gekennzeichnet, dass**

die magnetische Dünnschicht eine Dicke von 0,5 bis 5 nm (5 bis 50 Å) und die nichtmagnetische Dünnschicht aus Metall eine Dicke von 0,6 bis 1,2 nm (6 bis 12 Å) oder 1,7 bis 2,3 nm (17 bis 23 Å) hat.

2. Sensor nach Anspruch 1, bei dem die magnetische Dünnschicht aus $(Ni_x Co_{1-x})_{x'} Fe_{1-x'}$ hergestellt ist, wobei x den Wert 0,6 bis 1,0 und x' den Wert 0,7 bis 1,0 hat.

3. Sensor nach Anspruch 1, bei dem die magnetische Dünnschicht aus $(Co_y Ni_{1-y})_z Fe_{1-z}$ hergestellt ist, wobei y den Wert 0,4 bis 1,0 und z den Wert 0,8 bis 1,0 hat.

4. Sensor nach Anspruch 1, bei dem das Magnetowiderstandsmaterial erste und zweite magnetische Dünnschichten aufweist und dazwischen sandwichartig eine nichtmagnetische Dünnschicht eingeschoben ist, wobei die erste magnetische Dünnschicht aus $(Ni_x Co_{1-x})_{x'} Fe_{1-x'}$ und die zweite magnetische Dünnschicht aus $(Co_y Ni_{1-y})_z Fe_{1-z}$ hergestellt ist, wobei x den Wert 0,6 bis 1,0 , x' den Wert von 0,7 bis 1,0, y den Wert von 0,4 bis 1,0 und z den Wert von 0,8 bis 1,0 hat.

5. Sensor nach einem der vorhergehenden Ansprüche, bei dem der Bereich, in dem der durch die Richtung des äußeren magnetischen Feldes und die Richtung des durch das Magnetowiderstandsmaterial fließenden elektrischen Stroms gebildete Winkel kleiner als 45° ist, mehr 50 % umfasst.

6. Sensor nach einem der vorhergehenden Ansprüche, bei dem die nichtmagnetische Schicht aus Metall aus Cu, Ag, Au, Pt, oder Ru gebildet ist.


**Revendications**

1. Capteur magnétorésistif dans lequel,

un courant électrique circule au travers d'un matériau magnétorésistif pour mesurer l'intensité d'un champ magnétique externe par l'intermédiaire de la variation de résistance dudit matériau magnétorésistif provoquée par ledit champ magnétique,

le facteur de démagnétisation dudit matériau magnétorésistif dans la direction de la circulation du courant est plus faible que celui dans les autres directions,

la direction dudit champ magnétique externe est sensiblement parallèle à la direction de la circulation du courant, et

ledit matériau magnétorésistif est composé d'une membrane à réseau métallique artificielle comprenant une structure dans laquelle une couche de mince film magnétique et une couche de mince film métallique non magnétique sont stratifiées en alternance,

**caractérisé en ce que**

ladite couche de mince film magnétique présente une épaisseur de 0,5 à 5 nm (5 à 50 Å) et ladite couche de mince film métallique non magnétique présente une épaisseur de 0,6 à 1,2 nm (6 à 12 Å) ou bien de 1,7 à 2,3 nm (17 à 23 Å).

2. Capteur selon la revendication 1, dans lequel ladite couche de mince film magnétique est faite de $(Ni_xCo_{1-x})_{x'}Fe_{1-x'}$ dans lequel x représente 0,6 à 1,0 et x' représente 0,7 à 1,0.

3. Capteur d'effet selon la revendication 1, dans lequel ladite couche de mince film magnétique est faite de $(Co_yNi_{1-y})_zFe_{1-z}$ dans lequel y représente 0,4 à 1,0 et z représente 0,8 à 1,0.

4. Capteur selon la revendication 1, dans lequel ledit matériau à effet de magnétorésistance comprend des première et seconde couches magnétiques minces et une couche de mince film non magnétique prise en sandwich entre celles-ci, la première couche magnétique mince est faite de $(Ni_xCo_{1-x})_{x'}Fe_{1-x'}$ et la seconde couche magnétique mince est faite de $(Co_yNi_{1-y})_zFe_{1-z}$ dans lesquels x représente 0,6 à 1,0, x' représente 0,7 à 1,0, y représente 0,4 à 1,0 et z représente 0,8 à 1,0.

5. Capteur selon l'une quelconque des revendications précédentes, dans lequel la partie dans laquelle l'angle fait par la direction du champ magnétique externe et la direction du courant électrique circulant au travers du matériau à effet de magnétorésistance est inférieur à 45°, occupe plus de 50 %.

6. Capteur selon l'une quelconque des revendications précédentes, dans lequel la couche de mince film métallique non magnétique est formée à partir de Cu, Ag, Au, Pt ou Ru.

Fig. 1

(a)

H

I

Magneto-resistance
effect material

(b)

H

I

Magneto-resistance
effect material

Fig. 2

I (Direction of current)

→ H (Direction of magnet field)

Patterned artificial metallic lattice membrane